(19) Europäisches Patentamt
European Patent Office
Office européen des brevets

(11) **EP 3 343 249 B1**

(12) **EUROPÄISCHE PATENTSCHRIFT**

(45) Veröffentlichungstag und Bekanntmachung des Hinweises auf die Patenterteilung:
**20.11.2019 Patentblatt 2019/47**

(51) Int Cl.:
*G01W 1/10* $^{(2006.01)}$    *G06Q 10/04* $^{(2012.01)}$

(21) Anmeldenummer: **17450001.7**

(22) Anmeldetag: **03.01.2017**

(54) **VERFAHREN ZUR ERHÖHUNG DER RÄUMLICHEN AUFLÖSUNG EINER WETTERVORHERSAGE**

METHOD FOR INCREASING THE SPATIAL RESOLUTION OF A WEATHER PREDICTION

PROCÉDÉ D'AUGMENTATION DE LA RÉSOLUTION SPATIALE D'UNE PRÉVISION MÉTÉOROLOGIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**04.07.2018 Patentblatt 2018/27**

(73) Patentinhaber: **UBIMET GmbH**
**1220 Wien (AT)**

(72) Erfinder: **Spatzierer, Manfred**
**A-1100 Wien (AT)**

(74) Vertreter: **Keschmann, Marc**
**Haffner und Keschmann Patentanwälte GmbH**
**Schottengasse 3a**
**1010 Wien (AT)**

(56) Entgegenhaltungen:
- **D. MARAUN ET AL: "Precipitation downscaling under climate change: Recent developments to bridge the gap between dynamical models and the end user", REVIEWS OF GEOPHYSICS, Bd. 48, Nr. 3, 1. Januar 2010 (2010-01-01) , XP055370457, ISSN: 8755-1209, DOI: 10.1029/2009RG000314**
- **BOB GLAHN ET AL: "The Gridding of MOS", WEATHER AND FORECASTING, Bd. 24, Nr. 2, 1. April 2009 (2009-04-01), Seiten 520-529, XP055369562, US ISSN: 0882-8156, DOI: 10.1175/2008WAF2007080.1**
- **JONATHAN M. EDEN ET AL: "Downscaling of GCM-Simulated Precipitation Using Model Output Statistics", JOURNAL OF CLIMATE., Bd. 27, Nr. 1, 1. Januar 2014 (2014-01-01) , Seiten 312-324, XP055370455, US ISSN: 0894-8755, DOI: 10.1175/JCLI-D-13-00063.1**
- **Dieter Mayer ET AL: "VERA - Ein objektives Verfahren zur Analyse von meteorologischen Messwerten", Lebensministerium - Mitteilungsblatt des Hydrografischen Dienstes Nr.88, 1. Januar 2013 (2013-01-01), Seiten 9-34, XP055370529, Gefunden im Internet: URL:https://www.bmlfuw.gv.at/wasser/wasser -oesterreich/wasserkreislauf/hydrographie_ oesterreich/mitteilungen/Mitteilungsblatt8 8.html [gefunden am 2017-05-09]**

## Beschreibung

### Technisches Gebiet

Die Erfindung betrifft ein Verfahren, insbesondere ein computerimplementiertes Verfahren, zur Erhöhung der räumlichen Auflösung einer Wettervorhersage, bei welchem für Gitterpunkte eines ersten Gitters jeweils prognostizierte meteorologische Parameter vorliegen und die prognostizierten meteorologischen Parameter auf Gitterpunkte eines zweiten Gitters interpoliert werden, um interpolierte meteorologische Parameter zu erhalten, wobei die Gitterpunkte des zweiten Gitters räumlich höher aufgelöst sind als die Gitterpunkte des ersten Gitters. Die auf dem zweiten Gitter vorliegenden Parameterfelder können dabei mehr kleinskalige Informationen aufweisen, als bei Anwendung einer einfachen Interpolationsmethode.

Weiters betrifft die Erfindung ein Computerprogrammprodukt umfassend Programmcode-Mittel, die zur Durchführung der Schritte eines solchen Verfahrens geeignet sind, wenn das Computerprogrammprodukt auf einer Recheneinrichtung ausgeführt wird. Die Erfindung betrifft auch eine Recheneinrichtung, die zur Durchführung des genannten Verfahrens programmiert ist.

### Begriffsdefinitionen

In der Meteorologie wird eine Reihe von Verfahren verwendet, um den Zustand der Atmosphäre zu beschreiben und/oder zu modellieren und um daraus meteorologische Größen mit mathematischen Verfahren zu ermitteln. Im Rahmen der vorliegenden Erfindungsbeschreibung werden die relevanten meteorologischen Verfahren wie folgt definiert.

Unter einer "meteorologischen Analyse" ist eine möglichst genaue Beschreibung des momentanen Zustands der Atmosphäre zu einem bestimmten (in der Vergangenheit liegenden) Zeitpunkt zu verstehen. Ein "meteorologisches Analyseverfahren" ist ein Verfahren, das zur Interpolation von unregelmäßig im Raum verteilten Messwerten unter Einbeziehung von Zusatzinformationen dient. Im allgemeinsten Fall sind dies Abbildungen, die einer endlichen Anzahl von Messwerten bestimmter meteorologischer Parameter Felder dieser Parameter zuordnen.

Unter "Downscaling" wird eine räumliche Interpolation von meteorologischen Größen, die auf einem regelmäßigen Gitter bekannt sind, verstanden. Die Interpolation erfolgt unter Einbeziehung von Zusatzinformationen, die auf einem regelmäßigen, feiner aufgelösten Gitter bekannt sind.

Als "Postprocessing" werden Verfahren bezeichnet, die zu einer nachträglichen Verfeinerung von durch numerische Wettermodelle erzeugten Wetterprognosen verwendet werden. Dies können sowohl Downscaling-Verfahren als auch statistische Verfahren zur Feststellung und Korrektur von allfälligen systematischen Fehlern solcher Modelle (wie z.B. das weiter unten beschriebene MOS-Verfahren) sein. Mittels solcher Verfahren können auch Prognosen für Parameter, die nicht direkt vom numerischen Wettermodell vorhergesagt, aber genügend stark mit vorhergesagten Wetterparametern korrelieren, erstellt werden.

Unter einem "MOS-Verfahren" im weitesten Sinn wird ein Verfahr des maschinellen Lernens verstanden, bei dem Prognosen eines numerischen Wettermodells als unabhängige (d.h. erklärende) Variable verwendet werden. Zusätzlich können auch noch andere unabhängige Variablen in ein solches Verfahren eingehen. Als abhängige (d.h. erklärte) Variablen werden Messwerte oder von Messwerten abgeleitete Größen verwendet. MOS-Verfahren sind oft, aber nicht notwendigerweise, als Regressionsverfahren implementiert.

### Stand der Technik

Numerische Wettervorhersage-Modelle werden verwendet, um die zukünftige Entwicklung meteorologischer Parameter zu prognostizieren, indem die Differenzialgleichungen, welche die Physik der Atmosphäre bestimmen, durch numerische Methoden computerunterstützt gelöst werden. Numerische Wettervorhersage-Modelle berechnen den zukünftigen Zustand der Atmosphäre zu bestimmten Zeitpunkten auf Basis des mit Hilfe von Messungen ermittelten Ist-Zustands. Bei der numerischen Lösung werden die Differenzialgleichungen diskretisiert, sodass die Lösungen lediglich für Gitterpunkte eines räumlich und zeitlich endlich aufgelösten Gitters vorliegen, mit dem die Erde netzartig überzogen wird. Je nachdem, wie weit die Gitterpunkte auseinander liegen, variiert die Qualität der Prognose besonders bei Bodenparametern. Ein großer Abstand der Gitterpunkte bedingt lokale Ungenauigkeiten, wohingegen ein enges Gitter höhere Regionalität bietet. Bei gegenwärtig zum Einsatz gelangenden globalen numerischen Wettervorhersage-Modellen liegt der Gitterabstand bei 10 km und mehr. Die Prognose von Bodenparametern wie z.B. Tageshöchsttemperatur, Tagestiefsttemperatur oder Bodenwind für einen bestimmten Ort ist für den täglichen Gebrauch daher in vielen Fällen zu ungenau. Dies gilt besonders dann, wenn die meteorologischen Parameter durch sehr feinskalige orographische Effekte, wie z.B. Stau, Inversionen oder auf die Bodenbeschaffenheit zurückführbare Phänomene, wie Abweichungen in der Windgeschwindigkeit aufgrund der Bodenrauhigkeit, beeinflusst werden.

Es ist daher eine Reihe von Postprocessing-Verfahren bekannt geworden, mit welchen numerische Wettervorhersagen verfeinert werden können. Die Verfeinerung kann z.B. darin bestehen, dass die an den Gitterpunkten des numerischen Wettervorhersage-Modells zur Verfügung stehenden meteorologischen Parameter auf dazwischen liegende Punkte, wie z.B. auf Gitterpunkte eines räumlich höher aufgelösten Gitters, im Sinne eines Downscalings unter Berücksichtigung von lokalen Gegebenheiten interpoliert werden.

Im Rahmen von Postprocessing-Verfahren werden häufig auch statistische Methoden herangezogen. Model Output Statistics (MOS) ist ein etabliertes statistisches Verfahren, bei dem meist multilineare Regressionsgleichungen verwendet werden, die dazu dienen, die Vorhersageergebnisse numerischer Wettervorhersage-Modelle für einen bestimmten Ort anhand von Stationsmesswerten zu korrigieren. Bei MOS-Verfahren werden lange Zeitreihen (typischerweise zwei Jahre und mehr) von Messungen an Wetterstationen mit entsprechenden historischen numerischen Vorhersagen verglichen und die dabei gefundenen statistischen Zusammenhänge üblicherweise über lineare Regressionsmodelle abgebildet (vgl. Glahn H.R. and Lowry D.A: The Use of Model Output Statistics (MOS) in Objective Weather Forecasting, J. Appl. Meteor., 11, 1203-1211 (1972)). MOS-Vorhersagen sind im Normalfall deutlich genauer als durch einfache Interpolation aus dem gleichen numerischen Wettervorhersage-Modell abgeleitete Prognosen. Vor allem dann, wenn in der Umgebung der betrachteten Messpunkte Einflüsse auf die meteorologischen Parameter (wie Topographie oder Bodenoberflächen) lokal so stark variieren, dass dies in einem numerischen Modell mit üblicher Auflösung nicht abgebildet werden kann.

Die MOS-Vorhersage an einer Wetterstation wie oben beschrieben kann mathematisch wie folgt dargestellt werden: Der Messwert eines meteorologischen Parameters p (beispielsweise die Temperatur zwei Meter über dem Boden) an der Wetterstation $s$ zum Zeitpunkt $t$ wird bezeichnet als

$$M^s_{t,p}$$

und die Vorhersage eines numerischen Modells für einen meteorologischen Parameter $q$ an einem benachbarten Modellgitterpunkt $(x,y)$ für einen Zeitpunkt $t$ als

$$\varphi_{t,q}(x,y)$$

Üblicherweise stellt man für jeden Parameter $p$ und jede Station $s$ jeweils eigene Regressionsgleichungen auf, wobei man sich auf den der Station am nächsten gelegenen Modellgitterpunkt beschränken kann. Im Sinne einer kompakten Schreibweise werden die Indices $s$ und $p$ sowie die Koordinaten $(x,y)$ im Folgenden weggelassen.

Die Paare von Messwerten und numerischen Vorhersagen werden zu mehreren Zeitpunkten ermittelt, sodass eine entsprechende Zeitreihe vorliegt, die nun einer Regressionsanalyse unterzogen wird. Im Rahmen der Regressionsanalyse stellt der numerisch prognostizierte Parameter $q$ die erklärende Variable und der gemessene Parameter $p$ die erklärte Variable dar, sodass der Regressionsansatz wie folgt lautet:

$$M'_t = \alpha\varphi_t + \alpha_0 \qquad \text{(Formel 1)}$$

Es muss jedoch nicht zwingenderweise nur der dem Messparameter $p$ entsprechende Modellparameter als erklärende Variable verwendet werden: die an der Station gemessene Temperatur kann beispielsweise über eine Kombination aus Modelltemperatur, -feuchtigkeit und -druck erklärt werden. Der Regressionsansatz lautet dann (in vereinfachter Schreibweise)

$$M'_t = \sum_q \alpha_q \varphi_{t,q} + \alpha_0 \quad \text{(Formel 2)}$$

und die Regressionskoeffizienten $\alpha_0$, $\alpha_q$ werden über die Minimierung von

$$\sum_t (M'_t - M_t)$$

bestimmt. Sind die Koeffizienten $\alpha_0$, $\alpha_q$ für eine Station s und einen Parameter $p$ bekannt, kann für jede zukünftige Modellvorhersage eine MOS-Prognose für diesen Parameter an dieser Station erstellt werden.

Da das Finden und Anwenden solcher statistischer Zusammenhänge einen deutlich geringeren Rechenaufwand darstellt als das Lösen der bestimmenden Differenzialgleichungen innerhalb eines numerischen Modells, kann eine MOS-Postprocessing Methode prinzipiell auf einem räumlich deutlich höher aufgelösten Gitter angewendet werden als dies für ein numerisches Wettervorhersage-Modell möglich ist.

Die Idee, die ursprünglich für die Anwendung an Wetterstationen (also unregelmäßig verteilten Punkten) konzipierte MOS-Methode zu verwenden, um verfeinerte Vorhersagen auf einem regelmäßigen Gitter zu erhalten, ist ebenfalls etabliert (siehe Glahn, B., Gilbert K., Cosgrove R., Ruth D.P. and Sheets K.: The Gridding of MOS, Wea. Forecasting, 24, 520-529 (2009)). Sie kann, wie in Glahn, B. and Dallavalle, J.P.: Gridded MOS--Techniques, Status, and Plans, Preprints, 18th Conference on Probability and Statistics in the Atmospheric Sciences, Atlanta, GA, Amer. Meteor. Soc., 2.1 beschrieben, prinzipiell auf drei Arten umgesetzt werden:

Im einfachsten, ersten Fall werden mittels des MOS-Verfahrens statistische Beziehungen (wie z.B. gemäß Formel 1 oder 2) an allen verfügbaren Wetterstationen aus historischen Daten abgeleitet und dann einfach an allen anderen Punkten (mit vergleichbaren meteorologischen Verhältnissen) des regelmäßigen Gitters für zukünftige Prognosen angewendet.

Im zweiten Fall werden die statistischen Beziehungen (wie z.B. gemäß Formel 1 oder 2) an den Wetterstationen abgeleitet und nur an diesen angewendet, um danach aus den Prognosen für die Orte der Wetterstationen mittels eines Analyseverfahrens Prognosen auf einem regelmäßigen Gitter zu berechnen.

Die dritte Möglichkeit besteht darin, bereits die Messwerte an den Wetterstationen über eine Analyse auf ein regelmäßiges Gitter zu interpolieren und dann die statistischen Zusammenhänge an jedem Punkt dieses Gitters abzuleiten und anzuwenden.

Ein meteorologisches Analyseverfahren zur Interpolation von meteorologischen Parametern ist das sogenannte VERA-Verfahren (Vienna Enhanced Resolution Analysis). Das VERA-Verfahren ist in den folgenden Artikeln näher beschrieben:

- Mayer, D., R. Steinacker, 2013: VERA - Ein objektives Verfahren zur Analyse von meteorologischen Messwerten. Mitteilungsblatt des Hydrographischen Dienstes in Österreich, 88, 9-44 (http://www.univie.ac.at/amk/veraflex/test/Facebook/Hyd rologisches_Mitteilungsblatt_VERA.pdf)
- Pöttschacher, W., R. Steinacker, and M. Dorninger, 1996: VERA - A high resolution analysis scheme for the atmosphere over complex terrain. Preprints, Seventh Int. Conf. on Mesoscale Processes, Reading, United Kingdom, Amer. Meteor. Soc., 245-247.

Ziel des VERA-Verfahrens ist es, Messinformationen von unregelmäßig verteilten Punkten unter Einbindung von statisch oder dynamisch vorab definierten Feldern (Fingerprints) auf einem regelmäßigen Gitter zu analysieren. Die Grundidee des VERA-Verfahrens besteht in der berechtigten Annahme, dass sich meteorologische Felder additiv aufgrund unterschiedlicher Einflüsse zusammensetzen (abhängig von Topographie oder Bodenoberflächen) und dass die davon unabhängige Komponente vergleichsweise schwache Gradienten und Krümmungen aufweist, also geringe räumliche 1. und 2. Ableitungen besitzt. Die Rauigkeit eines meteorologischen Feldes wird demnach durch die vorgegebenen und im Rahmen der Analyse gewichteten Fingerprintfelder getragen, wobei für die Gewichtungsfaktoren eine räumliche Variation zugelassen wird, jedoch ebenfalls unter Anwendung einer Glattheitsbedingung. Der in erster Linie von der Großwetterlage determinierte glatte Grundanteil wird als unerklärte Komponente bezeichnet, die gewichteten Fingerprintfelder stellen die erklärten Anteile dar.

Mathematisch betrachtet handelt es sich bei der VERA-Analyse um die Lösung eines Optimierungsproblems. An das Analysefeld wird einerseits die Bedingung nach minimaler Krümmung des unerklärten Anteils und der Gewichtungsfaktoren gestellt, und andererseits wird gefordert, dass auch die Differenz zwischen Analyse und Beobachtungswerten an den Stationspunkten minimal ist.

Durch geeignete Wahl der Fingerprintfelder ist es möglich, drei Komponenten zu separieren, denen unterschiedliche physikalische Bedeutungen zukommen:

1) Von Bodeneinflüssen unabhängiger und höheninvarianter Anteil (unerklärter Anteil)
2) Unmittelbar von Bodenbedeckung und Geländeform beeinflusster Anteil (sämtliche erklärten Anteile mit Ausnahme der durch die Höhe determinierte Komponente)
3) Vertikaler Gradient (Gewicht des topographischen Fingerprints)

Die Aufspaltung in diese Komponenten erlaubt ein räumliches Downscaling der Analyse vom Analysegitter mit Gitterpunktabständen im Bereich weniger Kilometer bis auf etwa 100 m. Sie ist lediglich von der Auflösung der Fingerprintfelder (Geländemodell sowie daraus abgeleitete Felder, Landbedeckung) abhängig.

Die Interpolation von unregelmäßig im Raum verteilten Messungen eines meteorologischen Parameters $p$ zum Zeitpunkt $t$ auf ein regelmäßiges Gitter gemäß dem VERA-Verfahren kann mathematisch wie folgt dargestellt werden:

$$\{M_{t,p}{}^{S}|s \in \textit{Liste der Stationen}\} \rightarrow A_{t,p}(x,y).$$

Wie oben beschrieben, kann das Analysefeld $A_{t,p}(x,y)$ als Summe eines unerklärten Anteils $\gamma_0$ und eines erklärten Anteils dargestellt werden, wobei der erklärte Anteil sich wiederum als Summe von Produkten aus zeitabhängigen Fingerprintgewichten $\gamma_k$ und zeitunabhängigen Fingerprints $\Psi_k$ (also den erklärenden statischen Feldern) darstellen lässt:

$$A_{t,p}(x, y) = \sum_k \gamma_{k,t,p}(x, y)\,\Psi_k(x, y) + \gamma_{0,t,p}(x, y).$$

Die Eingangsgrößen einer VERA-Analyse für den Parameter $p$ zum Zeitpunkt t sind also die Messwerte $\{M_{t,p}{}^{S}|s \in$ Liste der Stationen} sowie die Fingerprintfelder $\Psi(x,y)$. Deren Ergebnis bzw. Ausgabegrößen sind die Fingerprintgewichtsfelder $\gamma_{k,t,p}(x,y)$ sowie das Feld des unerklärten Anteils $\gamma_{0,t,p}(x,y)$ und schließlich (daraus zusammengesetzt) das Analysefeld $A_{t,p}(x,y)$. In D. Maraun ET AL: "Precipitation downscaling under climate change: Recent developments to bridge the gap between dynamical models and the end user", Reviews of Geophysics, Bd. 48, Nr. 3, 1. Januar 2010 werden verschiedene Downscaling-Verfahren miteinander verglichen.

Die beschriebenen Verfahren können das allgemeine Bedürfnis nach Wetterprognosen, die eine hohe qualitative Genauigkeit haben und in einer hohen räumlichen Auflösung vorliegen, nicht immer zufriedenstellend befriedigen und haben verschiedene Nachteile.

Die vorliegende Erfindung zielt darauf ab, die genannten Nachteile zu überwinden und die Prognosequalität von interpolierten meteorologischen Parametern weiter zu verbessern und die räumliche Auflösung weiter zu erhöhen.

## Beschreibung der Erfindung

Zur Lösung dieser Aufgabe besteht die Erfindung bei einem Verfahren der eingangs genannten Art im Wesentlichen darin, dass

- für Gitterpunkte des zweiten Gitters jeweils eine die Vergangenheit betreffende Zeitreihe von Ausgabegrößen eines meteorologischen Analyseverfahrens vorliegt, mit welchem an Wettermessstationen ermittelte Messdaten von meteorologischen Parametern auf die Gitterpunkte des zweiten Gitters interpoliert sind,
- dass für die Gitterpunkte des zweiten Gitters jeweils Daten vorliegen, die einen statistischen Zusammenhang zwischen der Zeitreihe von Ausgabegrößen des meteorologischen Analyseverfahrens und einer Zeitreihe von an Gitterpunkten des ersten geographischen Gitters in der Vergangenheit prognostizierten meteorologischen Parametern beschreiben,
- dass die den statistischen Zusammenhang beschreibenden Daten verwendet werden, um aus für die Zukunft prognostizierten meteorologischen Parametern, die für die Gitterpunkte des ersten Gitters vorliegen, für die Gitterpunkte des zweiten Gitters jeweils prognostizierte Ausgabegrößen des meteorologischen Analyseverfahrens zu ermitteln, und
- dass der Syntheseschritt des meteorologischen Analyseverfahrens mit den prognostizierten Ausgabegrößen durchgeführt wird, um an den Gitterpunkten des zweiten Gitters Prognosen der meteorologischen Parameter zu erhalten.

Das erfindungsgemäße Verfahren kombiniert somit ein Analyseverfahren (wie z.B. VERA), das räumlich unregelmäßig verteilte Messungen auf ein regelmäßiges Gitter interpoliert, mit einem statistischen Postprocessing-Verfahren (wie z.B. MOS), das in erster Linie systematische Fehler in numerischen Wettervorhersagemodellen ausgleichen soll. Durch das Postprocessing-Verfahren wird außerdem eine Vorhersage beliebiger Parameter, für die Zeitreihen vorliegen (wie beispielsweise die Fingerprintgewichte und der unerklärte Anteil der VERA-Analyse), in Abhängigkeit der numerischen Wettervorhersagen ermöglicht. Durch die Kombination beider Verfahren erreicht man eine Erhöhung der räumlichen Auflösung von Wettervorhersagen und eine Optimierung der Vorhersagequalität. Die Kombination erfolgt dabei nicht so, dass die Analysen mit einfacher Interpolation auf das Zielgitter und dort mittels Regression aus den Modelldaten approximiert werden. Statt dessen geht die Erfindung einen neuen Weg, indem das eine Verfahren in das andere integriert wird, nämlich derart, dass das statistische Postprocessing-Verfahren dazu verwendet wird, um wenigstens eine Ausgabegröße des Analyseverfahrens zu prognostizieren.

Das erfindungsgemäße Verfahren umfasst im Wesentlichen vier Schritte, von welchen die ersten zwei Schritte lediglich einmal durchgeführt werden müssen und die letzten zwei Schritte für jede Prognose erforderlich sind. Im ersten Schritt wird eine meteorologische Analyse vorgenommen, wobei aus historischen Messdaten Ausgabegrößen des Analyseverfahrens berechnet werden, sodass ein Archiv, d.h. eine Zeitreihe der errechneten Ausgabegrößen erhalten wird.

Die Zeitreihe erstreckt sich hierbei z.B. über mindestens ein Jahr, vorzugsweise über mindestens zwei Jahre. Im Detail wird bevorzugt so vorgegangen, dass in der Vergangenheit an Wettermessstationen ermittelte Messdaten von meteorologischen Parametern unter Verwendung des meteorologischen Analyseverfahrens auf Gitterpunkte des zweiten Gitters interpoliert werden, wobei das Interpolieren, in Bezug auf jeden Gitterpunkt des zweiten Gitters, das Berechnen der Ausgabegrößen des Analyseverfahrens umfasst und die Interpolation für eine Vielzahl von in der Vergangenheit liegenden Zeitpunkten vorgenommen wird.

Im zweiten Schritt werden statistische Zusammenhänge zwischen historischen numerischen Wetterprognosedaten und den im ersten Schritt berechneten Ausgabegrößen gefunden.

Im dritten Schritt erfolgt eine Prognose der Analyse-Ausgabegrößen für zukünftige Zeitpunkte mittels Anwendung der im zweiten Schritt gefundenen Zusammenhänge auf Grund von aktuellen numerischen Wetterprognosedaten.

Im vierten Schritt erfolgt die Synthese der prognostizierten Ausgabegrößen und der im Analyseverfahren verwendeten Zusatzinformationen, um an den Gitterpunkten des zweiten Gitters die gewünschten Prognosen der meteorologischen Parameter zu erhalten.

Hinsichtlich des Analyseverfahrens ist bevorzugt vorgesehen, dass das Analyseverfahren ein VERA-Verfahren umfasst, wobei das VERA-Verfahren, in Bezug auf jeden Gitterpunkt des zweiten Gitters, die Bildung einer Interpolationsfunktion umfasst, in welcher ein meteorologischer Parameter des jeweiligen Gitterpunkts als Funktion eines unerklärten Anteils und von mit Gewichtungsfaktoren gewichteten Fingerprintfeldern dargestellt wird, wobei der unerklärte Anteil und die Gewichtungsfaktoren die zuvor erwähnten Ausgabegrößen des Analyseverfahrens bilden. Wie einleitend ausgeführt, erlaubt das VERA-Verfahren in besonderem Maße die Berücksichtigung von ortsspezifischen Einflussfaktoren auf die gewünschten meteorologischen Parameter.

Hinsichtlich des statistischen Zusammenhangs im zweiten Schritt ist bevorzugt vorgesehen, dass der statistische Zusammenhang mittels Regressionsanalyse ermittelt wird.

Insbesondere umfasst die Regressionsanalyse ein Model Output Statistics (MOS)-Verfahren.

Vorzugsweise erfolgt die Integration der Regressionsanalyse in das VERA-Verfahren so, dass die Regressionsanalyse das Aufstellen wenigstens einer Regressionsgleichung umfasst, mit welcher eine Ausgabegröße des Analyseverfahrens als Linearkombination von an wenigstens einem Gitterpunkt des ersten Gitters in der Vergangenheit prognostizierten meteorologischen Parametern dargestellt wird.

Insbesondere erfolgt die Integration des Regressions- bzw. MOS-Verfahrens in das VERA-Verfahren so, dass wenigstens ein Gewichtungsfaktor und/oder der unerklärte Anteil als die mittels der wenigstens einen Regressionsgleichung darzustellende Ausgabegröße herangezogen wird.

Im Rahmen der Regressionsanalyse wird dann vorzugsweise so vorgegangen, dass die zu ermittelnde Ausgabegröße, also z.B. der wenigstens eine Gewichtungsfaktor und/oder der unerklärte Anteil des VERA-Verfahrens, die erklärte Variable darstellt und die Prognosen eines numerischen Wettermodells an Gitterpunkten des erstens Gitters (oder durch einfache Interpolation dieser Prognosen ermittelte Werte) die erklärenden Variablen darstellen. Im einfachsten Fall kann lediglich ein einziger aus dem numerischen Wettermodell kommender meteorologischer Parameter als erklärende Variable verwendet werden, sodass der Regressionsansatz entsprechend der oben angeführten Formel 1 lauten kann.

Die abhängige Variable in der Regressionsgleichung, insbesondere der wenigstens eine Gewichtungsfaktor und/oder der unerklärte Anteil des VERA-Verfahrens, kann bevorzugt auch eine Funktion von mehreren aus dem numerischen Wettermodell kommenden meteorologischen Parametern sein. Der Regressionsansatz lautet dann entsprechend der oben angeführten Formel 2. Mit anderen Worten ist hierbei vorgesehen, dass die Regressionsanalyse das Aufstellen wenigstens einer Regressionsgleichung umfasst, mit welcher eine Ausgabegröße des Analyseverfahrens als Linearkombination von an wenigstens einem Gitterpunkt des ersten Gitters in der Vergangenheit prognostizierten meteorologischen Parametern dargestellt wird.

Eine bevorzugte Ausführungsform sieht, wie an sich bekannt, vor, dass die als MOS-Verfahren ausgebildete Regressionsanalyse nach der Methode der kleinsten Quadrate durchgeführt wird.

Ein besonderer Vorteil des erfindungsgemäßen Verfahrens liegt darin, dass die mittels des statistischen Zusammenhangs, insbesondere des MOS-Verfahrens, im dritten Schritt des Verfahrens ermittelten Ausgabegrößen im Rahmen des VERA-Verfahrens (vierter Schritt) verwendet werden können, um ein weiteres "Downscaling" der resultierenden Prognosen vorzunehmen. Dies gelingt beispielsweise durch die Verwendung eines digitalen Geländemodells, das noch höher aufgelöst ist als das zweite Gitter. Der Syntheseschritt der VERA-Methode kann dann mit die höhere Auflösung repräsentierenden Fingerprintfeldern durchgeführt werden, während die Gewichtungsfaktoren und der unerklärte Anteil, der im dritten Schritt des Verfahrens für den nächstliegenden Gitterpunkt des zweiten Gitters ermittelt wurde, unverändert gelassen werden kann. Es wurde festgestellt, dass auf diese Art und Weise eine qualitativ hochwertige Vorhersage mit sehr hoher räumlicher Auflösung erreicht werden kann, wenn mittels der Fingerprintfelder eine entsprechend genaue Beschreibung der ortsspezifischen Einflussfaktoren gelingt.

Das erfindungsgemäße Verfahren ist zu diesem Zweck bevorzugt derart weitergebildet, dass die prognostizierten Ausgabegrößen in dem meteorologischen Analyseverfahren verwendet werden, um einen meteorologischen Parameter für einen benachbarten, zwischen den Gitterpunkten des zweiten Gitters liegenden Zwischenpunkt zu interpolieren.

Insbesondere wird für die Ermittlung des meteorologischen Parameters des Zwischenpunkts eine Interpolationsfunktion des VERA-Verfahrens verwendet, welche am Zwischenpunkt gültige Werte der Fingerprintfelder und entweder denselben unerklärten Anteil und dieselben Gewichtungsfaktoren wie der nächste Nachbarpunkt des zweiten Gitters oder aus den vier benachbarten Gitterpunkten des zweiten Gitters einfach interpolierte Werte des unerklärten Anteils und der Gewichtungsfaktoren aufweist.

Allgemein ist das erfindungsgemäße Verfahren für die Weiterverarbeitung von Prognoseparametern jeglicher Herkunft geeignet. Am häufigsten werden die prognostizierten meteorologischen Parameter mittels einer numerischen Wettervorhersage ermittelt.

Bezüglich der Auswahl der meteorologischen Parameter existieren ebenfalls keine Einschränkungen. Bevorzugt umfassen die meteorologischen Parameter die Lufttemperatur, die relative Luftfeuchte, den Luftdruck, die Windrichtung, die Windgeschwindigkeit, Windböen, Wolkenbedeckung und/oder die Niederschlagsmenge und/oder daraus ableitbare Parameter.

Mathematisch kann das erfindungsgemäße Verfahren in einer bevorzugten Ausbildung wie folgt dargestellt werden. Es wird zunächst entsprechend der einleitend erläuterten VERA-Methode von der folgenden VERA-Gleichung ausgegangen:

$$A_{t,p}(x,y) = \sum_k \gamma_{k,t,p}(x,y) \, \Psi_k(x,y) + \gamma_{0,t,p}(x,y).$$

Der erfindungsgemäße Ansatz ist es nun, für den unerklärten Anteil $\gamma_{0,t,p}(x,y)$ sowie die Fingerprintgewichte $\gamma_{k,t,p}(x,y)$ jeweils eigene MOS-Regressionsgleichungen aufzustellen. Zu diesem Zweck werden der unerklärte Anteil sowie die Fingerprintgewichte jeweils als Funktion von meteorologischen Parametern $\varphi$ angesetzt, und zwar als Linearkombination $\alpha_0 + \alpha_1\varphi_1 + \alpha_2\varphi_2 + ...$ Für jeden Parameter $p$ und an jedem Gitterpunkt $(x,y)$ gelten eigene Gleichungen, die entsprechenden Abhängigkeiten sollen der Kompaktheit halber im Folgenden wieder weggelassen werden:

$$\gamma'_{0,t} = \sum_q \alpha_{0,q} \, \varphi_{t,q} + \alpha_{0,0}$$

$$\gamma'_{k,t} = \sum_q \alpha_{k,q} \, \varphi_{t,q} + \alpha_{k,0}.$$

Nach Berechnung der Regressionskoeffizienten $\alpha_{0,0}$, $\alpha_{0,q}$ und $\alpha_{k,0}$, $\alpha_{k,q}$ durch die üblichen Minimierungen von

$$\sum_t (\gamma'_{0,t} - \gamma_{0,t})^2$$

und

$$\sum_t (\gamma'_{k,t} - \gamma_{k,t})^2$$

können nun für jede zukünftige Modellvorhersage die Anteile der "MOS-prognostizierten VERA-Analyse" berechnet werden.

**Ausführungsbeispiel**

Die Erfindung wird nachfolgend anhand eines Ausführungsbeispiels näher erläutert.

Schritt 1 - VERA-Analyse:

Im Rahmen der VERA-Analyse erfolgt die Interpolation von Messdaten meteorologischer Parameter, die an unregelmäßig verteilten Punkten (Wetterstationen) vorliegen, auf ein regelmäßiges Gitter unter Berücksichtigung von (insbesondere zeitlich konstanten) Zusatzinformationen (wie z.B. Orographie, Bodeneigenschaften). Die VERA-Analyse kann für jeden Zeitpunkt, für den Messdaten vorliegen, einzeln und unabhängig von allen anderen behandelten Zeitpunkten durchgeführt werden. Eingangsdaten sind die (für jeden Zeitpunkt unterschiedlichen) Messwerte sowie die (im Normalfall zeitlich konstanten, aber natürlich räumlich variierenden) Felder der Zusatzinformationen (Fingerprints). Ausgabedaten sind die räumlich und zeitlich variierenden Fingerprintgewichte sowie der ebenfalls räumlich und zeitlich variierende unerklärte Anteil der Analyse.

Die VERA-Analyse wird in der Praxis auf einem Gitter wählbarer räumlicher Auflösung durchgeführt, höchstens kann das die Auflösung, in der die Fingerprint-Felder vorliegen, sein. Im Normalfall wird aber eine gröbere Auflösung gewählt. Im ersten Schritt des hier beschriebenen Verfahrens wird die VERA-Analyse auf einem gröber als die Fingerprintfelder aufgelösten Gitter ("zweites Gitter") durchgeführt, wobei die Analyse in einem z.B. stündlichen Zeitraster vorgenommen wird, das sich insgesamt über zwei Jahre oder mehr erstreckt. Danach liegt für jeden räumlichen Punkt des gewählten Gitters eine Zeitreihe von Ausgabegrößen der VERA-Analyse vor, nämlich eine Zeitreihe für die Fingerprintgewichte und den unerklärten Anteil der Analyse.

Schritt 2 - Trainieren eines MOS-Verfahrens zur Vorhersage von Fingerprintgewichten und des unerklärten Analyseanteils:

Die Zeitreihen der Fingerprintgewichtsfelder sowie des unerklärten Analyseanteils aus Schritt 1 können für jeden Gitterpunkt und für jeden Fingerprinttyp einzeln betrachtet werden. Außerdem liegen für den gleichen Zeitraum für Gitterpunkte eines geringer aufgelösten Gitters ("erstes Gitter") archivierte Wettervorhersagen aus einem numerischen Modell vor. Nun werden in einem MOS-Ansatz die Zeitreihen der Fingerprintgewichte und des unerklärten Anteils mit Zeitreihen der historischen prognostizierten Wetterparameter aus dem numerischen Modell in einen statistischen Zusammenhang gebracht. Dabei stellen im vorliegenden Fall der MOS-Anwendung die Fingerprintgewichte und der unerklärte Anteil die abhängige (erklärte) Variable dar, während die prognostizierten Wetterparameter aus dem numerischen Modell als unabhängige (erklärende) Variable betrachtet werden. Der Umstand, dass die räumliche Auflösung des numerischen Wettermodells gröber ist als jene, in der die VERA-Analysen vorliegen, stellt kein Problem dar, da erwartet wird, dass räumliche Details dadurch erhalten werden, dass das MOS-Verfahren für jeden Punkt des VERA-Gitters separat durchgeführt wird. Wenn das MOS-Verfahren (wie üblich) auf einer linearen Regressionsanalyse basiert, erhält man als Ausgabedaten von Schritt 2 für jeden Punkt des VERA-Gitters ("zweites Gitter") Koeffizienten einer Regressionsgleichung, die einen Zusammenhang zwischen vorhergesagten Wetterparametern aus dem numerischen Modell und der jeweils betrachteten VERA-Komponente herstellt.

Schritt 1 und Schritt 2 müssen im Prinzip nur einmal durchgeführt werden. Die Ausgabedaten von Schritt 2 werden im nächsten Schritt auf regelmäßiger Basis (immer wenn eine neue Prognose des verwendeten numerischen Wettermodells vorliegt, also mehrmals täglich) angewendet.

Schritt 3 - Operationelle Verwendung des Modells zur regelmäßigen Vorhersage von VERA-Parametern:

Für jeden zukünftigen Zeitpunkt, für den man über eine numerische Wetterprognose (aber noch keine Messwerte und daher keine VERA-Analyse) verfügt, können nun die prognostizierten Wetterparameter aus dem Modell in die entsprechende, in Schritt 2 bestimmte, Regressionsgleichung eingesetzt und prognostizierte Fingerprintgewichte und den prognostizierten unerklärten Analyseanteils für alle Punkte des "zweiten" Gitters, auf dem die historischen Analysen (Schritt 1) vorliegen, berechnet werden.

Schritt 4 - Zusammensetzung der prognostizierten Analyse und VERA-Downscaling:

Einerseits kann man mit den in Schritt 3 berechneten Prognosen der Fingerprintgewichte und des unerklärten Anteils wieder eine prognostizierte Analyse auf dem "zweiten" Gitter zusammensetzen, andererseits kann man aber unter Verwendung feiner aufgelöster Fingerprintfelder ein weiteres Downscaling durchführen.

**Patentansprüche**

1. Verfahren zur Erhöhung der räumlichen Auflösung einer Wettervorhersage, bei welchem für Gitterpunkte eines ersten Gitters jeweils prognostizierte meteorologische Parameter vorliegen und die prognostizierten meteorologischen Parameter auf Gitterpunkte eines zweiten Gitters interpoliert werden, um interpolierte meteorologische Parameter zu erhalten, wobei die Gitterpunkte des zweiten Gitters räumlich höher aufgelöst sind als die Gitterpunkte des ersten Gitters, **dadurch gekennzeichnet,**

- **dass** für Gitterpunkte des zweiten Gitters jeweils eine die Vergangenheit betreffende Zeitreihe von Ausgabegrößen eines meteorologischen Analyseverfahrens vorliegt, mit welchem an Wettermessstationen ermittelte Messdaten von meteorologischen Parametern auf die Gitterpunkte des zweiten Gitters interpoliert sind,
- **dass** für die Gitterpunkte des zweiten Gitters jeweils Daten vorliegen, die einen statistischen Zusammenhang zwischen der Zeitreihe von Ausgabegrößen des meteorologischen Analyseverfahrens und einer Zeitreihe von an Gitterpunkten des ersten Gitters in der Vergangenheit prognostizierten meteorologischen Parametern beschreiben,
- **dass** die den statistischen Zusammenhang beschreibenden Daten verwendet werden, um aus für die Zukunft prognostizierten meteorologischen Parametern, die für die Gitterpunkte des ersten Gitters vorliegen, für die Gitterpunkte des zweiten Gitters jeweils prognostizierte Ausgabegrößen des meteorologischen Analyseverfahrens zu ermitteln, und
- **dass** ein Syntheseschritt des meteorologischen Analyseverfahrens mit den prognostizierten Ausgabegrößen durchgeführt wird, um an den Gitterpunkten des zweiten Gitters Prognosen der meteorologischen Parameter zu erhalten.

2. Verfahren nach Anspruch 1, **dadurch gekennzeichnet, dass** die die Vergangenheit betreffende Zeitreihe von Ausgabegrößen des meteorologischen Analyseverfahrens erhalten wird, indem in der Vergangenheit an Wettermessstationen ermittelte Messdaten von meteorologischen Parametern unter Verwendung des meteorologischen Analyseverfahrens auf Gitterpunkte des zweiten Gitters interpoliert werden, wobei das Interpolieren, in Bezug auf jeden Gitterpunkt des zweiten Gitters, das Berechnen der Ausgabegrößen des Analyseverfahrens umfasst und die Interpolation für eine Vielzahl von in der Vergangenheit liegenden Zeitpunkten vorgenommen wird.

3. Verfahren nach Anspruch 1 oder 2, **dadurch gekennzeichnet, dass** das Analyseverfahren ein VERA-Verfahren umfasst, wobei das VERA-Verfahren, in Bezug auf jeden Gitterpunkt des zweiten Gitters, die Bildung einer Interpolationsfunktion umfasst, in welcher ein meteorologischer Parameter des jeweiligen Gitterpunkts als Funktion eines unerklärten Anteils und von mit Gewichtungsfaktoren gewichteten Fingerprintfeldern dargestellt wird, wobei der unerklärte Anteil und die Gewichtungsfaktoren die Ausgabegrößen des Analyseverfahrens bilden.

4. Verfahren nach Anspruch 1, 2 oder 3, **dadurch gekennzeichnet, dass** der statistische Zusammenhang mittels Regressionsanalyse ermittelt wird.

5. Verfahren nach Anspruch 4, **dadurch gekennzeichnet, dass** die Regressionsanalyse das Aufstellen wenigstens einer Regressionsgleichung umfasst, mit welcher eine Ausgabegröße des Analyseverfahrens als Linearkombination von an wenigstens einem Gitterpunkt des ersten Gitters in der Vergangenheit prognostizierten meteorologischen Parametern dargestellt wird.

6. Verfahren nach Anspruch 5, **dadurch gekennzeichnet, dass** für jede Ausgabegröße des Analyseverfahrens eine eigene Regressionsgleichung aufgestellt wird.

7. Verfahren nach einem der Ansprüche 4 bis 6, **dadurch gekennzeichnet, dass** die Regressionsanalyse ein Model Output Statistics (MOS)-Verfahren umfasst oder ausbildet.

8. Verfahren nach einem der Ansprüche 4 bis 7, **dadurch gekennzeichnet, dass** die als MOS-Verfahren ausgebildete Regressionsanalyse nach der Methode der kleinsten Quadrate durchgeführt wird.

9. Verfahren nach einem der Ansprüche 1 bis 8, **dadurch gekennzeichnet, dass** die (für die Zukunft oder in der Vergangenheit) prognostizierten meteorologischen Parameter an den Gitterpunkten des ersten Gitters mittels einer numerischen Wettervorhersage ermittelt werden bzw. wurden.

10. Verfahren nach einem der Ansprüche 1 bis 9, **dadurch gekennzeichnet, dass** die prognostizierten Ausgabegrößen in dem meteorologischen Analyseverfahren verwendet werden, um einen meteorologischen Parameter für einen benachbarten, zwischen den Gitterpunkten des zweiten Gitters liegenden Zwischenpunkt zu interpolieren.

11. Verfahren nach Anspruch 10, **dadurch gekennzeichnet, dass** für die Ermittlung des meteorologischen Parameters des Zwischenpunkts das VERA-Verfahren verwendet wird, welches am Zwischenpunkt gültige Werte der Fingerprintfelder und denselben prognostizierten unerklärten Anteil und dieselben prognostizierten Gewichtungsfaktoren aufweist wie wenigstens ein benachbarter Gitterpunkt des zweiten Gitters oder ein daraus interpolierter Wert des unerklärten Anteils und der Gewichtungsfaktoren.

**12.** Verfahren nach einem der Ansprüche 1 bis 11, **dadurch gekennzeichnet, dass** die meteorologischen Parameter die Lufttemperatur, die relative Luftfeuchte, den Luftdruck, die Windrichtung, die Windgeschwindigkeit, Windböen, Wolkenbedeckung und/oder die Niederschlagsmenge und/oder daraus ableitbare Parameter umfassen.

**13.** Computerprogrammprodukt umfassend Programmcode-Mittel geeignet zur Durchführung der Schritte eines Verfahrens nach einem der Ansprüche 1 bis 12, wenn das Computerprogrammprodukt auf einer Recheneinrichtung ausgeführt wird.

**14.** Recheneinrichtung zur Durchführung des Verfahrens nach einem der Ansprüche 1 bis 12, **dadurch gekennzeichnet, dass** die Recheneinrichtung mit einem Computerprogrammprodukt nach Anspruch 13 programmiert ist.

**Claims**

**1.** A method for increasing the spatial resolution of a weather forecast, in which predicted meteorological parameters are available for grid points of a first grid and the predicted meteorological parameters are interpolated to grid points of a second grid so as to obtain interpolated meteorological parameters, wherein the grid points of the second grid have a higher spatial resolution than the grid points of the first grid,
**characterized in that**

- for grid points of the second grid a time series relating to the past, of output quantities of a meteorological analysis method is each present, said meteorological analysis method being configured to interpolate measured data of meteorological parameters determined in weather measuring stations to the grid points of the second grid;
- for the grid points of the second grid data describing a statistical correlation between the time series of output quantities of the meteorological analysis method and a time series of meteorological parameters that have been predicted in the past at grid points of the first grid are each present;
- the data describing the statistical correlation is used to determine, from meteorological parameters predicted for the future and available for the grid points of the first grid, predicted output quantities of the meteorological analysis method for the grid points of the second grid; and
- a synthesis step of the meteorological analysis method is performed with the predicted output quantities to obtain forecasts of the meteorological parameters in the grid points of the second grid.

**2.** A method according to claim 1, **characterized in that** the time series relating to the past, of output quantities of a meteorological analysis method is obtained **in that** measurement data of meteorological parameters determined in the past in weather measuring stations are interpolated to grid points of the second grid by using the meteorological analysis method, wherein interpolating, in respect to each grid point of the second grid, comprises the calculating of the output quantities of the analysis method, and said interpolating is effected for a multitude of times in the past.

**3.** A method according to claim 1 or 2, **characterized in that** the analysis method comprises a VERA method, said VERA method, in respect to each grid point of the second grid, comprising the establishing of an interpolation function in which a meteorological parameter of the respective grid point is described as a function of an unexplained portion and of fingerprint fields weighted with weighting factors, the unexplained portion and the weighting factors constituting the output quantities of the analysis method.

**4.** A method according to claim 1, 2 or 3, **characterized in that** the statistical correlation is determined by means of a regression analysis.

**5.** A method according to claim 4, **characterized in that** the regression analysis comprises the establishing of at least one regression equation by which an output quantity of the analysis method is described as a linear combination of meteorological parameters predicted in the past on at least one grid point of the first grid.

**6.** A method according to claim 5, **characterized in that** a separate regression equation is established for each output quantity of the analysis method.

**7.** A method according to any one of claims 4 to 6, **characterized in that** said regression analysis comprises or is configured as a model output statistics (MOS) method.

**8.** A method according to any one of claims 4 to 7, **characterized in that** the regression analysis configured as MOS method is performed according to the method of least squares.

9. A method according to claims 1 to 8, **characterized in that** the meteorological parameters predicted (for the future or in the past) are/were determined on the grid points of the first grid by a numerical weather forecast.

10. A method according to claims 1 to 9 , **characterized in that** the predicted output quantities are used in the meteorological analysis method for interpolating a meteorological parameter for a neighboring intermediate point located between the grid points of the second grid.

11. A method according to claim 10, **characterized in that**, for determining the meteorological parameter of the intermediate point, the VERA method is used, which, in said intermediate point, comprises valid fingerprint field values and the same predicted unexplained portion and the same predicted weighting factors as at least one neighboring grid point of the second grid or a value interpolated therefrom of the unexplained portion and the weighting factors.

12. A method according to claims 1 to 11, **characterized in that** the meteorological parameters comprise air temperature, relative humidity, air pressure, wind direction, wind speed, wind gusts, cloud cover and/or precipitation and/or parameters derivable therefrom.

13. A computer program product comprising program code means suitable for carrying out the steps of a method according to any one of claims 1 to 12, when the computer program product is implemented on a computing device.

14. A computing device for carrying out the method according to any one of claims 1 to 12, **characterized in that** the computing device is programmed with a computer program product according to claim 13.

## Revendications

1. Procédé d'augmentation de la résolution spatiale d'une prévision météorologique, dans lequel il existe des paramètres météorologiques respectivement prévisionnels pour des points de réseau d'un premier réseau et les paramètres météorologiques prévisionnels sont interpolés sur des points de réseau d'un second réseau, afin d'obtenir des paramètres météorologiques interpolés, dans lequel les points de réseau du second réseau sont de plus grande résolution spatiale que les points de réseau du premier réseau, **caractérisé en ce**

   - **qu'**il existe respectivement une série chronologique concernant le passé de grandeurs de sortie d'un procédé d'analyse météorologique pour des points de réseau du second réseau, avec lequel des données de mesure de paramètres météorologiques déterminées au niveau de stations de mesure météorologiques sont interpolées sur les points de réseau du second réseau,
   - **qu'**il existe respectivement des données pour les points de réseau du second réseau, qui décrivent une relation statistique entre la série chronologique de grandeurs de sortie du procédé d'analyse météorologique et une série chronologique de paramètres météorologiques prévisionnels dans le passé au niveau de points de réseau du premier réseau,
   - **que** les données décrivant la relation statistique sont utilisées afin de déterminer des grandeurs de sortie respectivement prévisionnelles du procédé d'analyse météorologique à partir de paramètres météorologiques prévisionnels pour le futur qui existent pour les points de réseau du premier réseau, pour les points de réseau du second réseau, et
   - **qu'**une étape de synthèse du procédé d'analyse météorologique est réalisée avec les grandeurs de sortie prévisionnelles afin d'obtenir des prévisions des paramètres météorologiques au niveau des points de réseau du second réseau.

2. Procédé selon la revendication 1, **caractérisé en ce que** la série chronologique concernant le passé de grandeurs de sortie du procédé d'analyse météorologique est obtenue en interpolant sur les points de réseau du second réseau des données de mesure de paramètres météorologiques déterminées dans le passé au niveau de stations de mesure météorologiques en utilisant le procédé d'analyse météorologique, dans lequel l'interpolation, par rapport à chaque point de réseau du second réseau, comprend le calcul des grandeurs de sortie du procédé d'analyse et l'interpolation est entreprise pour une pluralité de moments situés dans le passé.

3. Procédé selon la revendication 1 ou 2, **caractérisé en ce que** le procédé d'analyse comprend un procédé VERA, dans lequel le procédé VERA comprend, par rapport à chaque point de réseau du second réseau, la formation d'une fonction d'interpolation, dans laquelle un paramètre météorologique du point de réseau respectif est représenté en tant que fonction d'une part non expliquée et de champs d'empreintes pondérés avec des facteurs de pondération, dans lequel la part non expliquée et les facteurs de pondération forment les grandeurs de sortie du procédé d'analyse.

4. Procédé selon la revendication 1, 2 ou 3, **caractérisé en ce que** la relation statistique est déterminée par analyse de régression.

5. Procédé selon la revendication 4, **caractérisé en ce que** l'analyse de régression comprend la pose d'au moins une équation de régression, avec laquelle une grandeur de sortie du procédé d'analyse est représentée en tant que combinaison linéaire de paramètres météorologiques prévisionnels dans le passé au niveau d'au moins un point de réseau du premier réseau.

6. Procédé selon la revendication 5, **caractérisé en ce qu'**une propre équation de régression est posée pour chaque grandeur de sortie du procédé d'analyse.

7. Procédé selon l'une quelconque des revendications 4 à 6, **caractérisé en ce que** l'analyse de régression comprend ou constitue un procédé Model Output Statistics (MOS).

8. Procédé selon l'une quelconque des revendications 4 à 7, **caractérisé en ce que** l'analyse de régression constituée en tant que procédé MOS est réalisée selon la méthode des plus petits carrés.

9. Procédé selon l'une quelconque des revendications 1 à 8, **caractérisé en ce que** les paramètres météorologiques prévisionnels (pour le futur ou dans le passé) seront ou ont été déterminés au niveau des points de réseau du premier réseau au moyen d'une prévision météorologique numérique.

10. Procédé selon l'une quelconque des revendications 1 à 9, **caractérisé en ce que** les grandeurs de sortie prévisionnelles sont utilisées dans le procédé d'analyse météorologique afin d'interpoler un paramètre météorologique pour un point intermédiaire adjacent, situé entre les points de réseau du second réseau.

11. Procédé selon la revendication 10, **caractérisé en ce que** le procédé VERA est utilisé pour la détermination du paramètre météorologique du point intermédiaire, lequel présente au point intermédiaire des valeurs valables des champs d'empreintes et la même part non expliquée prévisionnelle et les mêmes facteurs de pondération prévisionnels qu'au moins un point de réseau adjacent du second réseau ou une valeur qui en est interpolée de la part non expliquée et des facteurs de pondération.

12. Procédé selon l'une quelconque des revendications 1 à 11, **caractérisé en ce que** les paramètres météorologiques comprennent la température de l'air, l'humidité relative, la pression atmosphérique, la direction du vent, la vitesse du vent, les rafales de vent, la couverture nuageuse et/ou les précipitations et/ou des paramètres en découlant.

13. Produit de programme informatique comprenant des moyens de code de programme adaptés à la réalisation des étapes d'un procédé selon l'une quelconque des revendications 1 à 12, lorsque le produit de programme informatique est exécuté sur un dispositif de calcul.

14. Dispositif de calcul pour la réalisation du procédé selon l'une quelconque des revendications 1 à 12, **caractérisé en ce que** le dispositif de calcul est programmé avec un produit de programme informatique selon la revendication 13.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur

- **GLAHN H.R. ; LOWRY D.A.** The Use of Model Output Statistics (MOS) in Objective Weather Forecasting. *J. Appl. Meteor.,* 1972, vol. 11, 1203-1211
- **GLAHN, B. ; GILBERT K. ; COSGROVE R. ; RUTH D.P. ; SHEETS K.** The Gridding of MOS. *Wea. Forecasting,* 2009, vol. 24, 520-529
- **GLAHN, B. ; DALLAVALLE, J.P.** Gridded MOS--Techniques, Status, and Plans, Preprints, 18th Conference on Probability and Statistics in the Atmospheric Sciences. Amer. Meteor. Soc,
- **MAYER, D. ; R. STEINACKER.** VERA - Ein objektives Verfahren zur Analyse von meteorologischen Messwerten. *Mitteilungsblatt des Hydrographischen Dienstes in Österreich,* 2013, vol. 88, 9-44
- VERA - A high resolution analysis scheme for the atmosphere over complex terrain. Preprints. **PÖTTSCHACHER, W. ; R. STEINACKER ; M. DORNINGER.** Seventh Int. Conf. on Mesoscale Processes, Reading. Amer. Meteor. Soc, 1996, 245-247
- **D. MARAUN et al.** Precipitation downscaling under climate change: Recent developments to bridge the gap between dynamical models and the end user. *Reviews of Geophysics,* 01. Januar 2010, vol. 48 (3